# EUROPEAN PATENT APPLICATION

(11) **EP 4 817 922 A1**
(43) Date of publication of application: **07.10.2026**
(21) Application number: 26150445.0
(22) Date of filing: 07.01.2026
(51) Int. Cl.: B60K 35/22, B60K 35/53, B60K 35/55, B60R 11/02

(54) **FLEXIBLE DISPLAY DEVICE**

(30) Priority: 31.03.2025 KR 20250041054
(71) Applicant: Hyundai Mobis Co., Ltd., Gangnam-gu Seoul (KR)
(72) Inventor: KIM, Hana, 16891 Yongin-si, Gyeonggi-do (KR); KIM, Yeon Soo, 16891 Yongin-si, Gyeonggi-do (KR); LEE, Joung Hoon, 16891 Yongin-si, Gyeonggi-do (KR)
(74) Representative: Jung, Minkyu

(57) **Abstract**

A flexible display device includes: a display configured to be flexibly deformable and to be movable in an up-down direction to be inserted or withdrawn, and displaying an image on a front surface; a housing including an opening with an open upper one side and an internal space for inserting or withdrawing the display; a plate disposed adjacent to one side of the display; a plurality of reinforcing bars including a ferromagnet attached to the plate and configured to support a rear surface opposite to the front surface of the display; and a bezel coupled with the display and sliding in the up-down direction so that the display is inserted or withdrawn.

## Description

### CROSS-REFERENCE TO RELATED APPLICATION

This application claims the benefit of and priority to Korean Patent Application No. 10-2025-0041054, filed on March 31, 2025, the entire disclosure(s) of which is hereby incorporated herein by reference in its entirety.

### TECHNICAL FIELD

The present disclosure relates to a flexible display device.

### BACKGROUND

The content described in this section simply provides background information for the present disclosure and does not constitute prior art.

A display device capable of providing various information may be installed in the interior of a vehicle, such as a center fascia or a dashboard. The display device may provide not only various information about the vehicle, but also various entertainment content. For example, the display device may play a video, receive terrestrial broadcasting or satellite broadcasting and display it on the screen, provide information for the convenience of the user, such as a vehicle's status, weather, and news, and perform a navigation function.

The problem with existing display devices is that their shape and location are fixed once they are installed in a vehicle.

Even when the shape and position of the display device can be changed, there is a problem that it is difficult to satisfy both design requirement of a consumer and durability requirement of the display device.

### SUMMARY

A main object of the present disclosure is to provide a flexible display device that can satisfy design requirement and durability requirement of a consumer while allowing a shape and position of the display device to be changed.

The problems to be solved by the present disclosure are not limited to the problems mentioned above, and other problems not mentioned can be clearly understood by those skilled in the art from the description below.

According to one embodiment of the present disclosure, the ferromagnet is attached to the plurality of reinforcing bars, and the ferromagnet is attached to the plate using magnetism, so that the plurality of reinforcing bars can support the display unit from the rear surface, thereby improving the durability of the display unit.

In addition, by forming the space between the combination part of the bezel and the second surface parallel to the combination part, the durability of the bezel supporting the display unit can be improved.

In addition, when the display unit is withdrawn, the first guide rail and the second guide rail coupled to the housing and the bezel form a 2-layer, thereby having an effect of improving the durability of the bezel and the display unit.

### BRIEF DESCRIPTION OF THE DRAWINGS

Fig. 1 is a perspective view illustrating a first state of a flexible display device according to one embodiment of the present disclosure.
Fig. 2 is an exploded perspective view of the flexible display device according to one embodiment of the present disclosure.
Fig. 3 is a cross-sectional view taken along line A-A' of Fig. 1.
Fig. 4 is a cross-sectional view illustrating a first state of the flexible display device according to one embodiment of the present disclosure taken along line B-B' of Fig. 1.
Fig. 5 is a cross-sectional view illustrating a second state of the flexible display device according to one embodiment of the present disclosure taken along line B-B' of Fig. 1.
Fig. 6 is a cross-sectional view taken along line C-C' of Fig. 1.

### DETAILED DESCRIPTION

The objects of the present disclosure are not limited to those particularly described hereinabove, and the above and other objects that the present disclosure can achieve should be clearly understood by those having ordinary skill in the art from the following detailed description.

Hereinafter, some embodiments of the present disclosure are described in detail with reference to the accompanying drawings. In the following description, like reference numerals preferably designate like elements, although the elements are shown in different drawings. Further, in the following description of some embodiments, a detailed description of known related components and functions is omitted for the purpose of clarity and brevity when such description would obscure the subject of the present disclosure.

Various ordinal numbers or alpha codes, such as first, second, i), ii), a), b), etc., are prefixed to describe the components of embodiments of the present disclosure. In addition, unless explicitly described to the contrary, the term "comprise" and variations thereof, such as "comprises" or "comprising", should be understood to imply the inclusion of stated elements but not the exclusion of any other elements. The same understanding should apply to similar terms such as "have," "include", and the like.

When components are described as 'connected', 'coupled', or 'linked' to another component, they are meant to not only directly 'connected', 'coupled', or 'linked' but also to indirectly 'connected', 'coupled', or 'linked' via one or more additional components.

The terms such as 'unit', 'module', and the like refer to units for processing at least one function or operation, which may be implemented by hardware, software, or a combination thereof. When a component, controller, device, element, apparatus, or the like of the present disclosure is described as having a purpose or performing an operation, function, or the like, the component, controller, device, element, apparatus, or the like should be considered herein as being "configured to" meet that purpose or to perform that operation or function.

Unless the contrary is indicated, the description of any one of embodiments is intended to apply to other embodiments.

The description of the present disclosure to be presented below in conjunction with the accompanying drawings is intended to describe exemplary embodiments of the present disclosure and is not intended to represent the only embodiments in which the technical idea of the present disclosure may be practiced.

In the present specification, an "upper and lower directions" mean a Z-axis direction illustrated in the drawings. The terms "upper portion", "upper direction", and "withdrawn direction" used in the present specification mean a +Z-axis direction, and "lower portion", "lower direction", and "insertion direction" mean a -Z-axis direction. In the present specification, "right-left direction", "both sides", and "lateral directions" mean a Y-axis direction illustrated in the drawings. The term "right" used in the present specification means a +Y-axis direction illustrated in the drawings. In the present specification, a "front-rear direction" means an X-axis direction illustrated in the drawings. The terms "front portion" and "front direction" used in the present specification mean a +X-axis direction, and "rear portion" and "rear direction" mean a -X-axis direction.

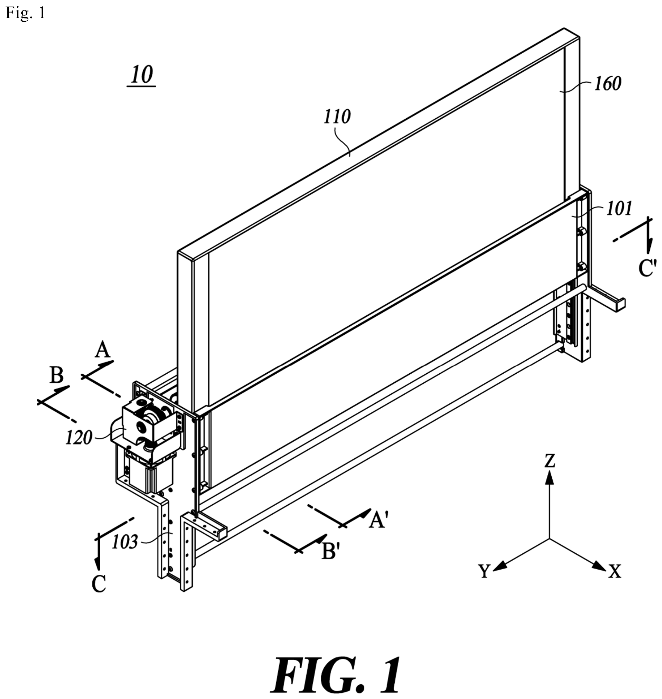

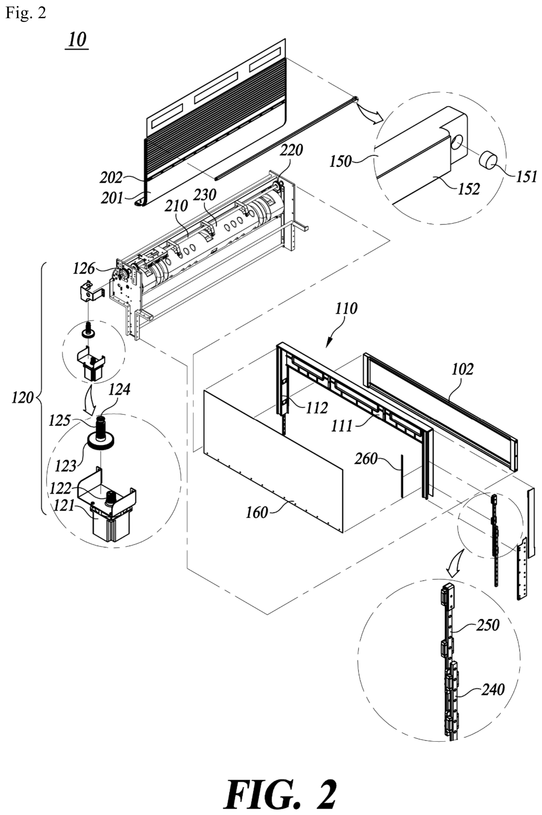

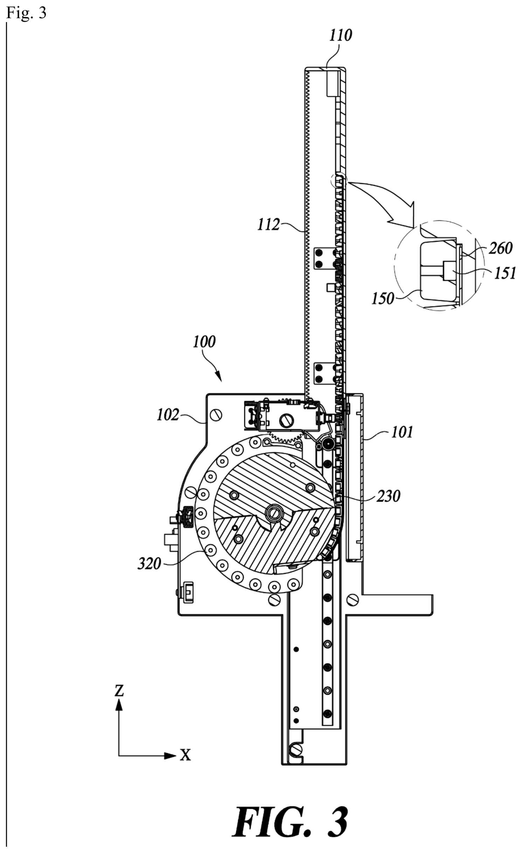

Fig. 1 is a perspective view of a first state of a flexible display device according to one embodiment of the present disclosure. Fig. 2 is an exploded perspective view of the flexible display device according to one embodiment of the present disclosure. Fig. 3 is a cross-sectional view taken along line A-A' of Fig. 1.

Referring to Figs. 1 to 3, a flexible display device 10 according to one embodiment of the present disclosure may include all or part of a display unit 160, a housing 100, a bezel 110, a plate 260, a plurality of reinforcing bars 150, and a plurality of rollers 320.

The flexible display device 10 according to one embodiment of the present disclosure may include all or part of a drum 230, an actuator 120, a first lead screw 210, and a first gear 220.

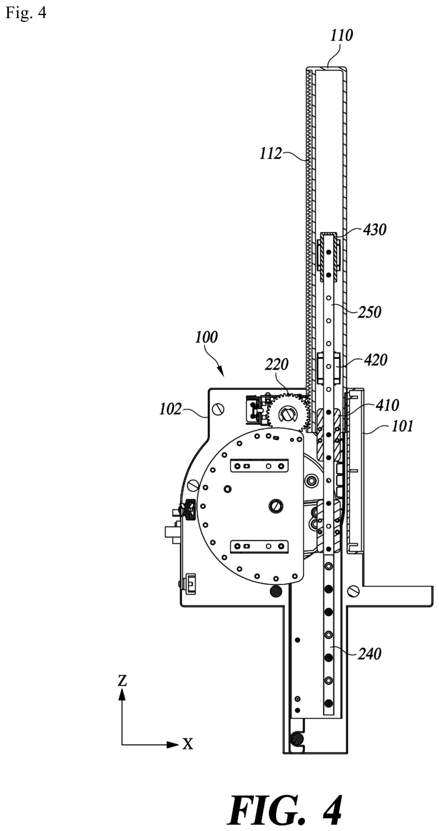

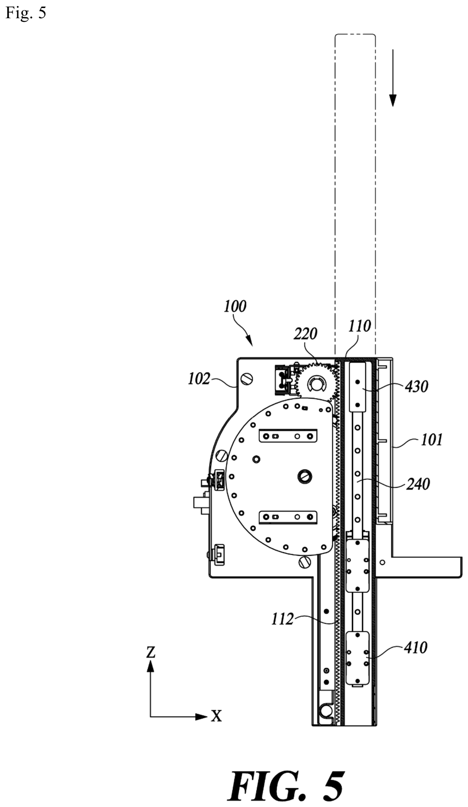

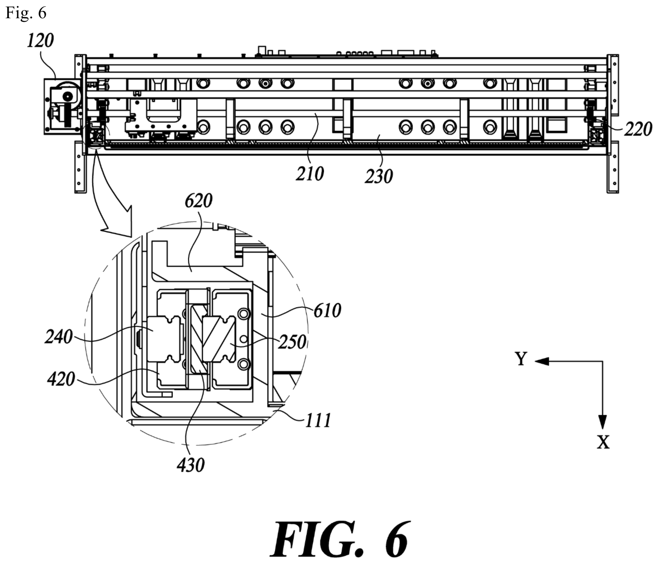

Fig. 4 is a cross-sectional view illustrating a first state of the flexible display device according to one embodiment of the present disclosure taken along line B-B' of Fig. 1. Fig. 5 is a cross-sectional view illustrating a second state of the flexible display device according to one embodiment of the present disclosure taken along line B-B' of Fig. 1. In Fig. 5, a state in which the bezel 110 is moved upward and the display unit 160 is withdrawn is indicated by dashed lines, and a state in which the bezel 110 is moved in a direction of the arrow and the display unit 160 is inserted is indicated by solid lines. Fig. 6 is a cross-sectional view taken along line C-C' of Fig. 1. In some embodiments, the display unit 160 may be referred to as a display.

In the present disclosure, the first state means a state in which the entire area of the display unit 160 is withdrawn upward and configured as a flat surface. The second state means a state in which the display unit 160 is inserted downward and one area of the display unit 160 is configured as a curved surface within the housing 100 and another area of the display unit 160 is configured as a flat surface.

Referring to Figs. 1 to 6, the flexible display device 10 according to one embodiment of the present disclosure may include all or part of at least one guide rail, at least one coupling block 410, at least one guide block 420, and at least one stopper. The at least one guide rail may include a first guide rail 240 and a second guide rail 250. The bezel 110 may include all or part of a combination part 111, a supporting part 112, a first surface 610, and a second surface 620.

The flexible display device 10 according to one embodiment of the present disclosure may include all or part of an extension film 201 and a protector 202.

The display unit 160 is configured to be flexibly deformable in one area and may display an image on the front surface. The display unit 160 may have the shape and position changed to the first state or the second state by the actuator 120. That is, the display unit 160 may be configured to be inserted or withdrawn by moving in the up-down direction.

The display unit 160 may include a film component (not illustrated), a cover glass (not illustrated), a display panel (not illustrated), a first supporting panel (not illustrated), a second supporting panel (not illustrated), the plurality of reinforcing bars 150, and a back cover (not illustrated).

The film member may protect the display unit 160. The film member may be an Anti Shatter Film (ASF), or the like. The ASF may prevent glass fragments from scattering and flying when the glass is broken. In other words, even when the cover glass is broken by an external impact, it is possible to protect the vehicle occupants by preventing the fragments of the cover glass from scattering.

The cover glass may cover the front surface of the display panel and protect the display panel. The cover glass may be an Ultra Thin Glass (UTG), but the present disclosure is not necessarily limited thereto.

The display panel may be formed of a flexible material that can be deformed at least in part. The display panel may be an Organic Light Emitting Diode (OLED), or the like, but the present disclosure is not necessarily limited thereto, and it is sufficient that an image can be viewed. The film component, the cover glass, and the display panel may be sequentially disposed in the front-back direction.

The housing 100 may include an opening (opening, not illustrated) with an open upper one side. The housing 100 has an internal space for the display unit 160 to be inserted or withdrawn. The housing 100 may include a front housing 101 disposed on the front surface of the flexible display device 10, a rear housing 102 disposed on the rear surface, and a side housing 103 disposed on the side surface, but the present disclosure is not necessarily limited thereto. For example, the housing 100 may include a front housing that covers both the side surface and the front surface of the flexible display device, and a rear housing disposed on the rear surface.

The drum 230 is disposed inside the housing 100. The drum 230 may be configured to rotate about an axis in the right-left direction, that is, the Y-axis direction, so that the display unit 160 may be inserted or withdrawn through the opening.

The first lead screw 210 may rotate about an axis in the right-left direction according to the driving of the actuator 120. The first gear 220 may be disposed so that the first lead screw 210 passes through the first gear 220. The first gear 220 may be configured so that the bezel 110 moves in the up-down direction according to the rotation of the first lead screw 210. The first lead screw 210 and the first gear 220 may be disposed above the drum 230.

The actuator 120 provides force so that the bezel 110 moves in the up-down direction to be inserted or withdrawn. The actuator 120 may be disposed so as to correspond to the first lead screw 210 and the first gear 220. That is, the actuator 120 may be located above the drum 230 and provide force so that the first lead screw 210 and the first gear 220 rotate. The first gear 220 may be configured to engage with the bezel 110, and the bezel 110 may in the up-down direction according to the rotation of the first gear 220. As the bezel 110 moves in the up-down direction, the display unit 160 may be converted into the first state or the second state.

When the actuator 120 is located at the lower portion, a configuration such as an extra guide assembly is required at the upper portion for the insertion or withdrawal of the display unit 160. Since the actuator 120 of the flexible display device 10 according to the present disclosure is located above the drum 230, stable insertion or withdrawal of the display unit 160 is possible without having the configuration such as the extra guide assembly, and the size of the entire package can be reduced. That is; by adopting a direct drive method instead of an indirect drive method, it is possible to have the actuator positioned at the upper portion so that the lifting structure such as the first gear 220 directly moves the bezel 110 in the up-down direction. With respect to the position of the actuator 120, the actuator 120 may be adjusted to be positioned on the side surface of the drum 230 within a range where the direct drive method can be implemented, and the present disclosure is not necessarily limited thereto with respect to the disposition or position of the actuator 120.

The actuator 120 of the flexible display device 10 according to one embodiment of the present disclosure may include all or part of a motor 121, a plurality of gears, a plurality of lead screws, and a plurality of worm wheels. The number, position, and arrangement of each of the motor, the plurality of gears, the plurality of lead screws, and the plurality of worm wheels may be adjusted within a range in which the actuator 120 is driven to provides force to rotate the first gear 220 and the first lead screw 210, and the bezel 110 and the display unit 160 can move in the up-down direction.

The actuator 120 of the flexible display device 10 according to one embodiment of the present disclosure may include all or part of the motor 121, a second gear 122, a third gear 123, a fourth gear 125, a second lead screw 124, and a worm wheel 126.

The motor 121 provides power to rotate the drum 230. When the motor 121 is driven, the first lead screw 210 and the first gear 220 rotate, thereby rotating the drum 230 and allowing the bezel 110 to move in the up-down direction.

The second gear 122 may be disposed above the motor 121. The second gear 122 may rotate in a first direction or a second direction opposite to the first direction depending on the rotation of the motor 121. The third gear 123 may be disposed at the rear of the second gear to mesh with the second gear 122. The third gear 123 may rotate in a direction opposite to the rotation direction of the second gear 122 depending on the rotation of the second gear 122.

The second lead screw 124 may be coupled to the upper portion of the third gear 123. By being coupled with the third gear 123, the second lead screw 124 may rotate in the same direction as the rotation direction of the third gear 123 according to the rotation of the third gear 123.

The second lead screw 124 pass through the fourth gear 125, and thus, the fourth gear 125 may be coupled with the second lead screw 124. That is, the fourth gear 125 may be disposed to surround an outer surface of the second lead screw 124. The fourth gear 125 may rotate in the same direction as the rotational directions of the third gear 123 and the second lead screw 124 as the third gear 123 and the second lead screw 124 rotate.

The worm wheel 126 may be disposed in front of the fourth gear 125 to mesh with the fourth gear 125. The worm wheel 126 may rotate in a direction perpendicular to the first direction or the second direction as the fourth gear 125 rotates. The first lead screw 210 passes through the worm wheel 126, and thus, the worm wheel 126 may be coupled with the first lead screw 210. The first lead screw 210 may be configured to rotate in the same direction as the rotational direction of the worm wheel 126 as the worm wheel 126 rotates.

With respect to the positions and arrangements of the motor 121, the second gear 122, the third gear 123, the fourth gear 125, the second lead screw 124, and the worm wheel 126, the present disclosure is not necessarily limited thereto. It is sufficient that the actuator 120 is configured to provide force so that the first gear 220 and the first lead screw 210 can rotate and the bezel 110 and the display unit 160 can move in the up-down direction as the actuator 120 is driven.

As illustrated in Fig. 2, the plurality of reinforcing bars 150 may be configured to support a rear surface opposite to the front surface of the display unit 160. Each of the plurality of reinforcing bars 150 may have a shape extending in the right-left direction. Each of the plurality of reinforcing bars 150 may be disposed in a direction parallel to the right-left direction, and may be attached to the display unit 160 while maintaining a predetermined gap. Each of the plurality of reinforcing bars 150 may include a ferromagnet 151 and an adhesive tape 152. The ferromagnet 151 may be disposed at one end of the plurality of reinforcing bars 150. The plurality of reinforcing bars 150 may provide rigidity to the display unit 160 by including the ferromagnet 151. That is, the ferromagnets 151 are disposed at both ends of each of the plurality of reinforcing bars 150, and the plurality of reinforcing bars 150 support the display unit 160 at the rear of the display unit to improve durability. The plurality of reinforcing bars 150 may also be referred to as an apron.

The plate 260 may be disposed adjacent to one side of the display unit 160. The plate 260 may be disposed adjacent to both sides of the display unit 160 and configured such that the ferromagnet 151 is attached to the plate 260. By attaching the ferromagnet to the plate, the ferromagnets 151 on both sides of the plurality of reinforcing bars 150 may support each of the central portions of the plurality of reinforcing bars 150, thereby improving durability.

The adhesive tape 152 serves to attach each of the plurality of reinforcing bars 150 to the display unit 160. However, the present disclosure is not necessarily limited thereto, and any material capable of attaching the plurality of reinforcing bars 150 to the display unit 160, such as tape, adhesive, or liquid glue, is sufficient. For example, the plurality of reinforcing bars 150 may be attached by applying an adhesive to an area where the plurality of reinforcing bars 150 are attached to the display unit 160.

As illustrated in Fig. 3, the plurality of rollers 320 may be spaced apart and disposed on the outer surface of the drum 230. The plurality of rollers 320 may be disposed along at least a portion of the outer surface perimeter of the drum 230. The plurality of rollers 320 may rotate about an axis in the right-left direction. When the display unit 160 is inserted or withdrawn, the plurality of rollers 320 serve to guide the movement of the plurality of reinforcing bars 150 and the display unit 160. In the second state where the display unit 160 is inserted, the plurality of reinforcing bars 150 may be disposed to come into contact with the plurality of rollers 320 and the drum 230.

The bezel 110 may be configured to be coupled with the display unit 160 and to slide in the up-down direction so that the display unit 160 may be inserted or withdrawn. The bezel 110 may include the combination part 111, the first surface 610, and the second surface 620. The display unit 160 may be coupled to the front surface of the combination part 111. The first surface 610 may be formed to protrude in the rear direction from a point on one side of the combination part 111. The second surface 620 may be formed to extend from an end of the first surface 610 in the lateral direction the bezel 110 in parallel with the combination part 111. For example, on the right side of the flexible display device 10, the first surface 610 may be formed to protrude in the -X-axis direction from a point on the right side of the combination part 111. The second surface 620 may be formed to extend parallel to the combination part 111 from the end of the first surface toward the +Y axis.

Since the bezel 110 includes the combination part 111, the first surface 610, and the second surface 620, a space may be formed between the combination part 111 and the second surface 620. With respect to the protrusion or extension direction of the first surface 610 and the second surface 620, the present disclosure is not necessarily limited thereto. The protrusion or extension direction of the first surface 610 and the second surface 620 is sufficient as long as the first surface 610 and the second surface 620 are provided so that the space can be formed between the first surface 610 and the combination part 111. Since the space is formed between the first surface 610 and the combination part 111, the bezel 110 can support the weight and load of the display unit 160 and the plurality of reinforcing bars 150, and there is an effect of improving durability.

The flexible display device 10 according to one embodiment of the present disclosure may accommodate at least one guide rail in the space formed between the combination part 111 and the second surface 620. At least one guide rail may support one side surface of a bezel 110.

At least one guide rail may include the first guide rail 240 and the second guide rail 250. The first guide rail 240 may be coupled to the housing 100. The second guide rail 250 may be coupled to the bezel 110. The first guide rail 240 and the second guide rail 250 may have a shape extending in the up-down direction. The first guide rail 240 and the second guide rail 250 may be disposed parallel to each other.

In the second state, the first guide rail 240 and the second guide rail 250 may be disposed in a direction parallel to the Z-axis at positions corresponding to each other. When the bezel 110 moves upward and the display unit 160 is withdrawn, the first guide rail 240 coupled to the housing 100 does not move, but the second guide rail 250 coupled to the bezel 110 moves upward. Therefore, in the first state, the first guide rail 240 and the second guide rail 250 can be disposed in parallel as in the second state, but the second guide rail 250 may be disposed in a form in which the second guide rail 250 moves upward more than the first guide rail 240.

As illustrated in Fig. 2, in the first state, a portion of the lower part of the second guide rail 250 and a portion of the upper part of the first guide rail 240 may be disposed at heights corresponding to each other. That is, a 2-layer may be formed at a portion where the first guide rail 240 and the second guide rail 250 overlap. Since the first guide rail 240 and the second guide rail 250 form the 2-layer, there is an effect of more stably supporting the bezel 110 and the display unit 160 in a state where the display unit 160 is withdrawn.

As illustrated in Fig. 6, at least one coupling block 410 may be placed between the first guide rail 240 and the second guide rail 250. The at least one coupling block 410 serves to couple the first guide rail 240 and the second guide rail 250 so that the second guide rail 250 can slide. The at least one coupling block 410 may be configured so that the first guide rail 240 guides the second guide rail 250 when the bezel 110 moves in the up-down direction.

At least one guide block 420 may be coupled to the first guide rail 240 or the second guide rail 250. The at least one guide block 420 may be configured so that the first guide rail 240 may be stably coupled to the housing 100. The at least one guide block 420 may be configured so that the second guide rail 250 may be stably coupled to the bezel 110. The at least one guide block 420 may be configured so that when the bezel 110 moves in the up-down direction and the display unit 160 is inserted or withdrawn, the first guide rail 240 guides the movement of the second guide rail 250.

At least one stopper may include a first stopper 430 and a second stopper 440. The first stopper 430 and the second stopper 440 may limit a range in which at least one coupling block 410 moves. The first stopper 430 may be located above the second stopper 440. The first stopper 430 may be disposed on one side of the upper portion of the second guide rail 250. The second stopper 440 may be disposed between the first guide rail 240 and the second guide rail 250. The first stopper 430 and the second stopper 440 serve to prevent at least one coupling block 410 from moving upward from the second guide rail 250. Regarding the arrangement of the first stopper 430 and the second stopper, the present disclosure is not necessarily limited thereto, and it is sufficient as long as at least one coupling block 410 and the second guide rail 250 can move within a predetermined range.

The flexible display device 10 according to one embodiment of the present disclosure may include all or part of the extension film 201 and the protector 202. The bezel 110 may include the combination part 111 and the supporting part 112.

The display unit 160 may be attached to the front surface of the combination part 111. The supporting part is formed to extend downward from one end of the combination part. The entire bezel 110, including the combination part 111 and the supporting part 112, may be moved in the up-down direction so that the display unit 160 can be inserted or withdrawn.

The extension film 201 may be attached to the lower end portion of the display unit 160. The extension film 201 may be configured to guide the display unit 160 when the bezel 110 moves in the up-down direction and the display unit 160 is inserted or withdrawn. That is, the extension film 201 serves to extend the display unit 160. In the first state, even when the display unit 160 is moved upward and withdrawn, a portion of the extension film 201 may be configured to support the display unit 160 by surrounding the drum.

In the first state, that is, when the display unit 160 is withdrawn, the entire section of the display unit 160 can be disposed to correspond in parallel with a part of the combination part 111 and the supporting part 112 of the bezel 110. Accordingly, in the first state, a part of the extension film 201 may be disposed to correspond in parallel with another part of the supporting part 112, and the other part of the extension film 201 may be disposed in a form that surrounds the drum.

In the second state, that is, when the display unit 160 is inserted, a part of the upper part of the display unit 160 may be disposed to correspond parallel to the combination part 111 of the bezel 110. Another part of the display unit 160 may be disposed in a form that surrounds the drum 230. That is, the display unit 160 may include a curved section. Accordingly, the entire section of the extension film 201 may be disposed in a curved form in the second state.

The protector 202 may be configured to be fixed by combining the display unit 160 and the extension film 201. The display unit 160 and the protector 202 may be fixed by combining the protector 202 at a portion where the display unit 160 and the protector 202 overlap and are combined. The protector 202 may be screw-coupled to the display unit 160 and the extension film 201, but the present disclosure is not necessarily limited thereto. The coupling means of the protector 202 may be any means by which the display unit 160 and the extension film 201 can be combined and fixed.

The flexible display device 10 according to one embodiment of the present disclosure may include a light sensor (not illustrated). The light sensor may be configured to control the position of the bezel 110 or the display unit 160. When the bezel 110 or the display unit 160 is inserted or withdrawn, the light sensor detects the position of the bezel 110 or the display unit 160, thereby controlling the bezel 110 or the display unit 160 to move in the up-down direction within a predetermined range. When the flexible display device 10 does not include a light sensor, the flexible display device 10 may include other components such as an inductive sensor or a limit switch, which can detect the position of the bezel 110 or the display unit 160 and control the range of movement.

Although embodiments of the present disclosure have been described for illustrative purposes, those having ordinary skill in the art should appreciate that various modifications, additions, and substitutions are possible without departing from the idea and scope of the present disclosure. Therefore, the embodiments of the present disclosure have been described for the sake of brevity and clarity. The scope of the technical idea of the embodiments of the present disclosure is not limited by the illustrations. Accordingly, one of ordinary skill would understand that the scope of the present disclosure is not to be limited by the above explicitly described embodiments but by the claims and equivalents thereof.

## Claims

1. A flexible display device comprising:
a display configured to be flexibly deformable and to be movable in an up-down direction to be inserted or withdrawn, and displaying an image on a front surface;
a housing including an opening with an open upper one side and an internal space for inserting or withdrawing the display;
a plate disposed adjacent to one side of the display;
a plurality of reinforcing bars including a ferromagnet attached to the plate and configured to support a rear surface opposite to the front surface of the display; and
a bezel coupled with the display and sliding in the up-down direction so that the display is inserted or withdrawn.

2. The flexible display device of claim 1, further comprising:
a drum disposed inside the housing and rotating about an axis in a right-left direction perpendicular to the up-down direction so that the display passes through the opening to be inserted or withdrawn;
an actuator that provides force so that the bezel moves in the up-down direction and is inserted or withdrawn;
a first lead screw that rotates about an axis in the right-left direction according to a driving of the actuator; and
a first gear that is disposed so that the first lead screw penetrates and is configured so that the bezel moves in the up-down direction according to the rotation of the first lead screw,
wherein the first lead screw and the first gear are disposed above the drum.

3. The flexible display device of claim 2, wherein the actuator is disposed so as to correspond to the first lead screw and the first gear, and includes at least one of a motor, a plurality of gears, a plurality of lead screws, and a plurality of worm wheels.

4. The flexible display device of any one of claims 1 to 3, further comprising at least one guide rail supporting one side surface of the bezel,
wherein the bezel includes
a combination part where the display is coupled to a front surface,
a first surface formed to protrude from a point on one side of the combination part in a rearward direction, and
a second surface formed to extend from an end of the first surface in a lateral direction of the bezel in parallel with the combination part, and
the at least one guide rail in a space formed between the combination part and the second surface.

5. The flexible display device of claim 4, wherein the at least one guide rail includes a first guide rail coupled to the housing and a second guide rail coupled to the bezel.

6. The flexible display device of claim 5, further comprising at least one coupling block,
wherein the at least one coupling block is configured so that the first guide rail guides the second guide rail when the bezel moves in the up-down direction by slidably coupling the second guide rail.

7. The flexible display device of any one of claims 1 to 6, wherein the bezel includes a combination part where the display is coupled to a front surface and a supporting part extending downward from one end of the combination part.

8. The flexible display device of claim 7, wherein when the display is inserted,
a portion of an upper portion of the display is disposed to correspond parallel to the combination part, and
when the display is withdrawn,
an entire area of the display is disposed to correspond parallel to the combination part and the supporting part.

9. The flexible display device of any one of claims 1 to 8, further comprising:
an extension film coupled to a lower portion of the display and configured to guide the display when the bezel moves in the up-down direction and the display is inserted or withdrawn; and
a protector configured so that the display and the extension film are coupled to be fixed.

10. The flexible display device of any one of claims 1 to 9, further comprising a light sensor configured to control a position of the bezel or the display.
